# EUROPEAN PATENT APPLICATION

(11) **EP 4 671 864 A1**
(43) Date of publication of application: **31.12.2025**
(21) Application number: 24184990.0
(22) Date of filing: 27.06.2024
(51) Int. Cl.: G03F 7/00

(54) **METHOD OF DETERMINING A COMMON POINT IN IMAGES, APPARATUS AND COMPUTER PROGRAM**

(71) Applicant: ASML Netherlands B.V., 5500 AH Veldhoven (NL)
(72) Inventor: VAN LEEST, Adriaan Johan, 5500 AH Veldhoven (NL); MATHIJSSEN, Simon Gijsbert Josephus, 5500 AH Veldhoven (NL); KAPEL, Pieter Anthon, 5500 AH Veldhoven (NL)
(74) Representative: ASML Netherlands B.V.

(57) **Abstract**

Disclosed is a method of determining a common point for each of a normal target image and complementary target image of at least one pair of target images. The method comprises obtaining the at least one pair of target images, each pair of target images of the at least one pair of target images comprising a normal target image and a complementary target image, the normal target image being obtained from a normal diffraction order of a pair of corresponding diffraction orders as diffracted from a target on a substrate and the complementary target image being obtained from a complementary diffraction order of said pair of corresponding diffraction orders; and determining the common point for each target image of the at least one pair of target images by referring each the target image to an application specific reference image.

## Description

### FIELD OF THE INVENTION

The present invention relates to methods and apparatus for metrology usable, for example, in the manufacture of devices by lithographic techniques and to methods of manufacturing devices using lithographic techniques.

### BACKGROUND ART

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g., including part of, one, or several dies) on a substrate (e.g., a silicon wafer). Transfer of the pattern is typically via imaging onto a layer of radiation-sensitive material (resist) provided on the substrate. In general, a single substrate will contain a network of adjacent target portions that are successively patterned. In lithographic processes, it is desirable frequently to make measurements of the structures created, e.g., for process control and verification. Various tools for making such measurements are known, including scanning electron microscopes, which are often used to measure critical dimension (CD), and specialized tools to measure overlay, a measure of the accuracy of alignment of two layers in a device. Overlay may be described in terms of the degree of misalignment between the two layers, for example reference to a measured overlay of 1nm may describe a situation where two layers are misaligned by 1nm.

Recently, various forms of scatterometers have been developed for use in the lithographic field. These devices direct a beam of radiation onto a target and measure one or more properties of the scattered radiation - e.g., intensity at a single angle of reflection as a function of wavelength; intensity at one or more wavelengths as a function of reflected angle; or polarization as a function of reflected angle - to obtain a "spectrum" from which a property of interest of the target can be determined. Determination of the property of interest may be performed by various techniques: e.g., reconstruction of the target by iterative approaches such as rigorous coupled wave analysis or finite element methods; library searches; and principal component analysis.

The targets used by conventional scatterometers are relatively large, e.g., 40µm by 40µm, gratings and the measurement beam generates a spot that is smaller than the grating (i.e., the grating is underfilled). This simplifies mathematical reconstruction of the target as it can be regarded as infinite. However, in order to reduce the size of the targets, e.g., to 10µm by 10µm or less, e.g., so they can be positioned in amongst product features, rather than in the scribe lane, metrology has been proposed in which the grating is made smaller than the measurement spot (i.e., the grating is overfilled). Typically such targets are measured using dark field scatterometry in which the zeroth order of diffraction (corresponding to a specular reflection) is blocked, and only higher orders processed. Examples of dark field metrology can be found in international patent applications WO 2009/078708 and WO 2009/106279 which documents are hereby incorporated by reference in their entirety. Further developments of the technique have been described in patent publications US20110027704A, US20110043791A and US20120242970A. The contents of all these applications are also incorporated herein by reference. Diffraction-based overlay using dark-field detection of the diffraction orders enables overlay measurements on smaller targets. These targets can be smaller than the illumination spot and may be surrounded by product structures on a wafer. Targets can comprise multiple gratings which can be measured in one image.

In the known metrology technique, overlay measurement results are obtained by measuring the target twice under certain conditions, while either rotating the target or changing the illumination mode or imaging mode to obtain separately the -1st and the +1st diffraction order intensities. The intensity asymmetry, a comparison of these diffraction order intensities, for a given target provides a measurement of target asymmetry, that is asymmetry in the target. This asymmetry in the target can be used as an indicator of overlay (undesired misalignment of two layers), i.e., positional error in the substrate plane and/or focus i.e., positional error perpendicular to the substrate plane. Another known method measures a phase difference between dark-field images of two different types of sub-target.

As the target size decreases beyond the aforementioned 10µm size, e.g., to less than 9µm, less than 8µm, less than 7µm or less than or equal to 6µm, the region of interest (ROI), corresponding to a region of the target over which the sensed diffraction order intensity is averaged, also decreases.

It is therefore desirable to improve the measurement accuracy of a parameter of interest (e.g., overlay) on such smaller targets.

### SUMMARY

In a first aspect of the invention there is provided a method of determining a common point for each target image of at least one pair of target images, the method comprising: obtaining the at least one pair of target images, each pair of target images of the at least one pair of target images comprising a normal target image and a complementary target image, the normal target image being obtained from a normal diffraction order of a pair of corresponding diffraction orders as diffracted from a target on a substrate and the complementary target image being obtained from a complementary diffraction order of the pair of corresponding diffraction orders; and determining the common point for each target image of the at least one pair of target images by referring each the target image to an application specific reference image.

In another aspect a computer program comprising processor readable instructions which, when run on suitable processor controlled apparatus, cause the processor controlled apparatus to perform the method of the first aspect and a computer program carrier comprising such a computer program. The processor controlled apparatus may comprise a metrology apparatus or processing arrangement therefor.

Further features and advantages of the invention, as well as the structure and operation of various embodiments of the invention, are described in detail below with reference to the accompanying drawings. It is noted that the invention is not limited to the specific embodiments described herein. Such embodiments are presented herein for illustrative purposes only. Additional embodiments will be apparent to persons skilled in the relevant art(s) based on the teachings contained herein.

### BRIEF DESCRIPTION OF THE DRAWINGS

Embodiments of the invention will now be described, by way of example only, with reference to the accompanying drawings in which:
Figure 1 schematically depicts a lithographic apparatus;
Figure 2 schematically depicts a lithographic cell or cluster;
Figure 3 depicts a schematic representation of holistic lithography, representing a cooperation between key technologies to optimize semiconductor manufacturing;
Figure 4 is a schematic illustration of a scatterometry apparatus for metrology;
Figure 5(a) comprises a schematic diagram of a dark field scatterometer for metrology for use in measuring targets according to embodiments of the invention using a first pair of illumination apertures;
Figure 5(b) illustrates a detail of diffraction spectrum of a target grating for a given direction of illumination;
Figure 5(c) illustrates a second pair of illumination apertures providing further illumination modes in using the scatterometer for diffraction based overlay measurements; and
Figure 5(d) illustrates a third pair of illumination apertures combining the first and second pair of apertures;
Figure 6 depicts a known form of multiple grating target and an outline of a measurement spot on a substrate;
Figure 7 depicts an image of the target of Figure 6 obtained in the scatterometer of Figure 5;
Figure 8 is an example captured image of a small target subject to oscillation effects; and
Figure 9 is a flowchart describing a method according to embodiments of the invention.

### DETAILED DESCRIPTION OF EXEMPLARY EMBODIMENTS

Before describing embodiments of the invention in detail, it is instructive to present an example environment in which embodiments of the present invention may be implemented.

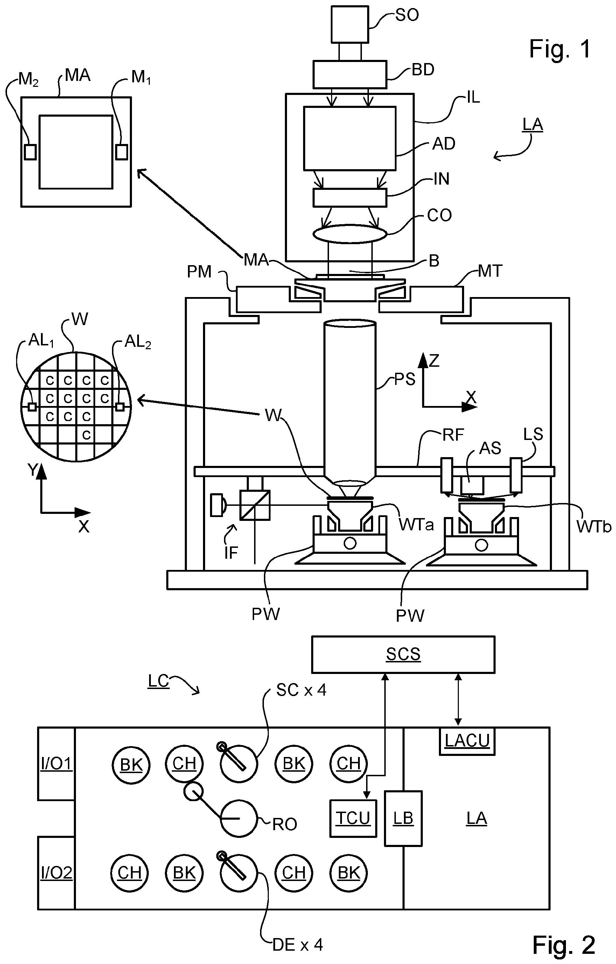

Figure 1 schematically depicts a lithographic apparatus LA. The apparatus includes an illumination optical system (illuminator) IL configured to condition a radiation beam B (e.g., UV radiation or DUV radiation), a patterning device support or support structure (e.g., a mask table) MT constructed to support a patterning device (e.g., a mask) MA and connected to a first positioner PM configured to accurately position the patterning device in accordance with certain parameters; a substrate table (e.g., a wafer table) WTa, WTb, constructed to hold a substrate (e.g., a resist coated wafer) W and connected to a second positioner PW configured to accurately position the substrate in accordance with certain parameters; and a projection optical system (e.g., a refractive projection lens system) PS configured to project a pattern imparted to the radiation beam B by patterning device MA onto a target portion C (e.g., including one or more dies) of the substrate W. In addition, the lithographic apparatus includes a reference frame RF.

The illumination optical system may include various types of optical components, such as refractive, reflective, magnetic, electromagnetic, electrostatic or other types of optical components, or any combination thereof, for directing, shaping, or controlling radiation.

The patterning device support holds the patterning device in a manner that depends on the orientation of the patterning device, the design of the lithographic apparatus, and other conditions, such as for example whether or not the patterning device is held in a vacuum environment. The patterning device support can use mechanical, vacuum, electrostatic or other clamping techniques to hold the patterning device. The patterning device support may be a frame or a table, for example, which may be fixed or movable as required. The patterning device support may ensure that the patterning device is at a desired position, for example with respect to the projection system. Any use of the terms "reticle" or "mask" herein may be considered synonymous with the more general term "patterning device."

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

The patterning device may be transmissive or reflective. Examples of patterning devices include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions. The tilted mirrors impart a pattern in a radiation beam, which is reflected by the mirror matrix.

As here depicted, the apparatus is of a transmissive type (e.g., employing a transmissive mask). Alternatively, the apparatus may be of a reflective type (e.g., employing a programmable mirror array of a type as referred to above, or employing a reflective mask).

The lithographic apparatus may also be of a type wherein at least a portion of the substrate may be covered by a liquid having a relatively high refractive index, e.g., water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems. The term "immersion" as used herein does not mean that a structure, such as a substrate, must be submerged in liquid, but rather only means that liquid is located between the projection system and the substrate during exposure.

Referring to Figure 1, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD including, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may include an adjuster AD for adjusting the angular intensity distribution of the radiation beam. Generally, at least the outer and/or inner radial extent (commonly referred to as σ-outer and σ-inner, respectively) of the intensity distribution in a pupil plane of the illuminator can be adjusted. In addition, the illuminator IL may include various other components, such as an integrator IN and a condenser CO. The illuminator may be used to condition the radiation beam, to have a desired uniformity and intensity distribution in its cross section.

The radiation beam B is incident on the patterning device (e.g., mask) MA, which is held on the patterning device support (e.g., mask table MT), and is patterned by the patterning device. Having traversed the patterning device (e.g., mask) MA, the radiation beam B passes through the projection optical system PS, which focuses the beam onto a target portion C of the substrate W, thereby projecting an image of the pattern on the target portion C. With the aid of the second positioner PW and position sensor IF (e.g., an interferometric device, linear encoder, 2-D encoder or capacitive sensor), the substrate table WT can be moved accurately, e.g., so as to position different target portions C in the path of the radiation beam B. Similarly, the first positioner PM and another position sensor (which is not explicitly depicted in Figure 1) can be used to accurately position the patterning device (e.g., mask) MA with respect to the path of the radiation beam B, e.g., after mechanical retrieval from a mask library, or during a scan.

Patterning device (e.g., mask) MA and substrate W may be aligned using mask alignment marks M₁, M₂ and substrate alignment marks AL₁, AL₂. Although the substrate alignment marks as illustrated occupy dedicated target portions, they may be located in spaces between target portions (these are known as scribe-lane alignment marks). Similarly, in situations in which more than one die is provided on the patterning device (e.g., mask) MA, the mask alignment marks may be located between the dies. Small alignment markers may also be included within dies, in amongst the device features, in which case it is desirable that the markers be as small as possible and not require any different imaging or process conditions than adjacent features. The alignment system, which detects the alignment markers is described further below.

Lithographic apparatus LA in this example is of a so-called dual stage type which has two substrate tables WTa, WTb and two stations - an exposure station and a measurement station - between which the substrate tables can be exchanged. While one substrate on one substrate table is being exposed at the exposure station, another substrate can be loaded onto the other substrate table at the measurement station and various preparatory steps carried out. The preparatory steps may include mapping the surface control of the substrate using a level sensor LS and measuring the position of alignment markers on the substrate using an alignment sensor AS. This enables a substantial increase in the throughput of the apparatus.

The depicted apparatus can be used in a variety of modes, including for example a step mode or a scan mode. The construction and operation of lithographic apparatus is well known to those skilled in the art and need not be described further for an understanding of the present invention.

The terms "radiation" and "beam" used herein encompass all types of electromagnetic radiation, including ultraviolet (UV) radiation (e.g., having a wavelength of or about 365, 355, 248, 193, 157 or 126 nm) and extreme ultra-violet (EUV) radiation (e.g., having a wavelength in the range of 5-20 nm), as well as particle beams, such as ion beams or electron beams.

The term "lens", where the context allows, may refer to any one or combination of various types of optical components, including refractive, reflective, magnetic, electromagnetic and electrostatic optical components.

As shown in Figure 2, a lithographic apparatus corresponding to the lithographic apparatus LA of Figure 1, forms part of a lithographic system, referred to as a lithographic cell LC, a lithocell or a cluster. The lithographic cell LC may also include apparatus to perform pre- and post-exposure processes on a substrate. Conventionally these include the following process devices: spin coaters SC to deposit resist layers, developers DE to develop exposed resist, chill plates CH and bake plates BK. A substrate handler, or robot, RO picks up substrates from input/output ports I/O1, I/O2, moves them between the different process devices and delivers them to the loading bay LB of the lithographic apparatus. These devices, which are often collectively referred to as the track, are under the control of a track control unit TCU which is itself controlled by the supervisory control system SCS, which also controls the lithographic apparatus via lithography control unit LACU. Thus, the different apparatus can be operated to maximize throughput and processing efficiency.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection tool, which may also be referred to as a metrology tool or metrology apparatus, is used to determine properties of the substrates W, and in particular, how properties of different substrates W vary or how properties associated with different layers of the same substrate W vary from layer to layer. The inspection tool may alternatively be constructed to identify defects on the substrate W and may, for example, be part of the lithocell LC, or may be integrated into the lithographic apparatus LA, or may even be a stand-alone device. The inspection tool may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

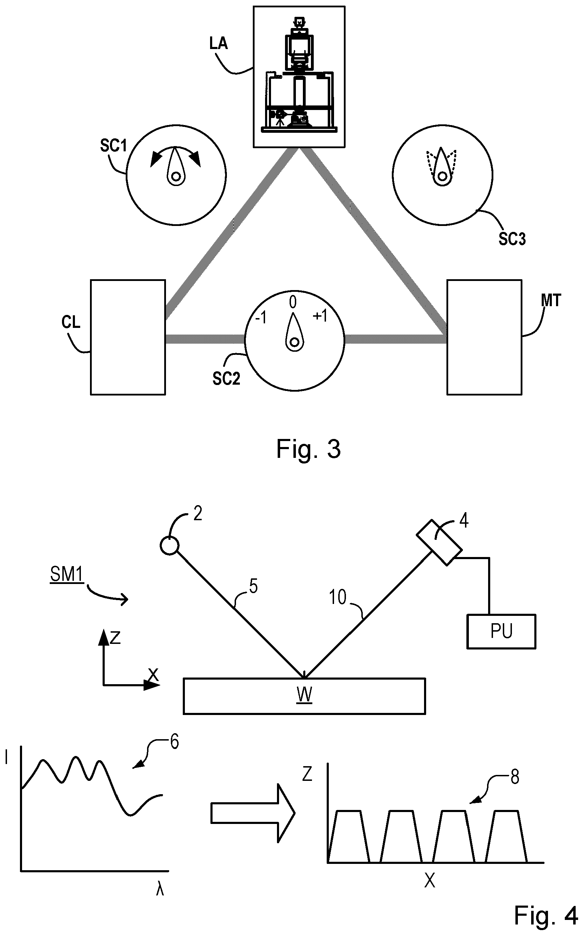

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Figure 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Figure 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT) to predict whether defects may be present due to e.g. sub-optimal processing (depicted in Figure 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Figure 3 by the multiple arrows in the third scale SC3).

In lithographic processes, it is desirable to make frequently measurements of the structures created, e.g., for process control and verification. Various tools for making such measurements are known, including scanning electron microscopes or various forms of metrology apparatuses, such as scatterometers. Examples of known scatterometers often rely on provision of dedicated metrology targets, such as underfilled targets (a target, in the form of a simple grating or overlapping gratings in different layers, that is large enough that a measurement beam generates a spot that is smaller than the grating) or overfilled targets (whereby the illumination spot partially or completely contains the target). Further, the use of metrology tools, for example an angular resolved scatterometer illuminating an underfilled target, such as a grating, allows the use of so-called reconstruction methods where the properties of the grating can be calculated by simulating interaction of scattered radiation with a mathematical model of the target structure and comparing the simulation results with those of a measurement. Parameters of the model are adjusted until the simulated interaction produces a diffraction pattern similar to that observed from the real target.

Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent publications US20100328655A, US2011102753A, US20120044470A, US20110249244A, US20110026032A or EP1,628,164A, incorporated herein by reference in their entirety. Aforementioned scatterometers can measure in one image multiple targets from multiple gratings using light from soft x-ray and visible to near-IR wave range.

A metrology apparatus is depicted in Figure 4 as scatterometer SM1. The scatterometer SM1 comprises a broadband (white light) radiation projector 2 which projects radiation 5 onto a substrate W. The reflected or scattered radiation 10 is passed to a spectrometer detector 4, which measures a spectrum 6 (i.e. a measurement of intensity I as a function of wavelength λ) of the specular reflected radiation 10. From this data, the structure or profile 8 of the substrate giving rise to the detected spectrum may be reconstructed by processing unit PU, e.g. by Rigorous Coupled Wave Analysis and non-linear regression or by comparison with a library of simulated spectra. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

In a first embodiment, the scatterometer is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer is a spectroscopic scatterometer. In such spectroscopic scatterometer, the radiation emitted by a radiation source is directed onto the target and the reflected or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer is an ellipsometric scatterometer. The ellipsometric scatterometer allows for determining parameters of a lithographic process by measuring scattered radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer, the scatterometer is adapted to measure the overlay of two misaligned gratings or periodic structures by measuring asymmetry in the reflected spectrum and/or the detection configuration, the asymmetry being related to the extent of the overlay. The two (typically overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for measuring overlay error between the two layers containing periodic structures as target is measured through asymmetry of the periodic structures may be found in PCT patent application publication no. WO 2011/012624 or US patent application US 20160161863, incorporated herein by reference in its entirety. Other parameters of interest may be focus and dose. Focus and dose may be determined simultaneously by scatterometry (or alternatively by scanning electron microscopy) as described in US patent application US2011-0249244, incorporated herein by reference in its entirety.

The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1 incorporated herein by reference in its entirety.

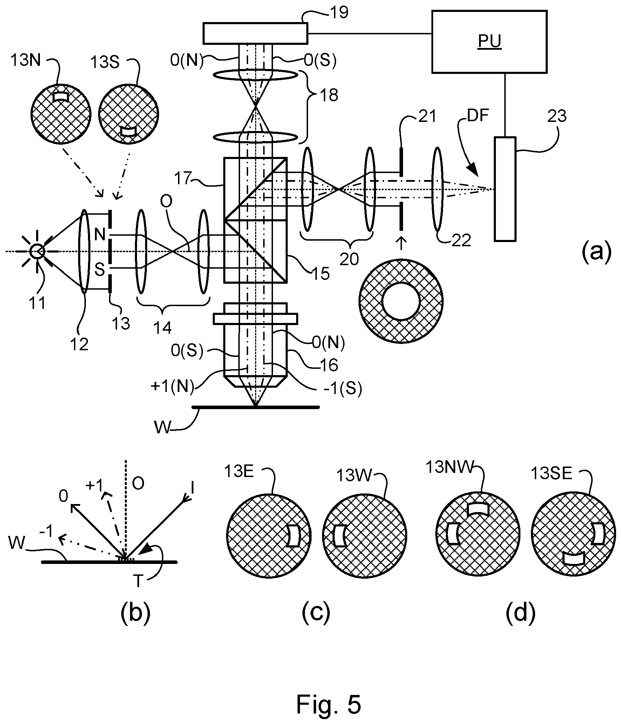

A metrology apparatus suitable for use in embodiments of the invention is shown in Figure 5(a). A target T and diffracted rays of measurement radiation used to illuminate the target are illustrated in more detail in Figure 5(b). The metrology apparatus illustrated is of a type known as a dark field metrology apparatus. The metrology apparatus may be a stand-alone device or incorporated in either the lithographic apparatus LA, e.g., at the measurement station, or the lithographic cell LC. An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 14 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane. In particular, this can be done by inserting an aperture plate 13 of suitable form between lenses 12 and 14, in a plane which is a back-projected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures, such as those which enable simultaneous illumination and detection from two opposing directions in combination with optical wedges to separate the resultant images. The rest of the pupil plane is desirably dark as any unnecessary light outside the desired illumination mode will interfere with the desired measurement signals.

As shown in Figure 5(b), target T is placed with substrate W normal to the optical axis O of objective lens 16. The substrate W may be supported by a support (not shown). A ray of measurement radiation I impinging on target T from an angle off the axis O gives rise to a zeroth order ray (solid line 0) and two first order rays (dot-chain line +1 and double dot-chain line -1). It should be remembered that with an overfilled small target, these rays are just one of many parallel rays covering the area of the substrate including metrology target T and other features. Since the aperture in plate 13 has a finite width (necessary to admit a useful quantity of light), the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the targets and the illumination angles can be designed or adjusted so that the first order rays entering the objective lens are closely aligned with the central optical axis. The rays illustrated in Figure 5(a) and 5(b) are shown somewhat off axis, purely to enable them to be more easily distinguished in the diagram.

At least the 0 and +1 orders diffracted by the target T on substrate W are collected by objective lens 16 and directed back through beam splitter 15. Returning to Figure 5(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled -1(S)) are the ones which enter the lens 16.

A second beam splitter 17 divides the diffracted beams into two measurement branches. In a first measurement branch, optical system 18 forms a diffraction spectrum (pupil plane image) of the target on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for focusing the metrology apparatus and/or normalizing intensity measurements of the first order beam. The pupil plane image can also be used for many measurement purposes such as reconstruction.

In the second measurement branch, optical system 20, 22 forms an image of the target T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or +1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

The particular forms of aperture plate 13 and field stop 21 shown in Figure 3 are purely examples. In another embodiment of the invention, on-axis illumination of the targets is used and an aperture stop with an off-axis aperture is used to pass substantially only one first order of diffracted light to the sensor. In yet other embodiments, 2nd, 3rd and higher order beams (not shown in Figure 5) can be used in measurements, instead of or in addition to the first order beams.

In order to make the measurement radiation adaptable to these different types of measurement, the aperture plate 13 may comprise a number of aperture patterns formed around a disc, which rotates to bring a desired pattern into place. Note that aperture plate 13N or 13S can only be used to measure gratings oriented in one direction (X or Y depending on the set-up). For measurement of an orthogonal grating, rotation of the target through 90° and 270° might be implemented. Different aperture plates are shown in Figures 5(c) and (d). The use of these, and numerous other variations and applications of the apparatus are described in prior published applications, mentioned above.

In particular, it is known to use a quartered aperture plate providing illumination in only two diagonally opposing quadrants of the illumination pupil. Such an illumination arrangement, in combination with suitable directing optics (e.g., a wedge arrangement) in the detection branch, enables simultaneous capture of +1 and -1 diffraction images of each of X and Y gratings in each of two substrate orientations (e.g., 0 and 180 degrees).

It is known to use an apparatus such as illustrated in Figure 5(a) to measure overlay. To achieve this, overlay targets may be printed on a wafer in two layers. One method of overlay metrology (sometimes referred to as micro-diffraction based overlay (µDBO) infers overlay from an asymmetry imbalance in corresponding diffraction orders (normal and complementary diffraction orders such as +1 and -1 orders) from targets comprising a respective grating in each layer. Typically, in µDBO the gratings have the same single pitch in each layer, though there may be an imposed bias between the two targets.

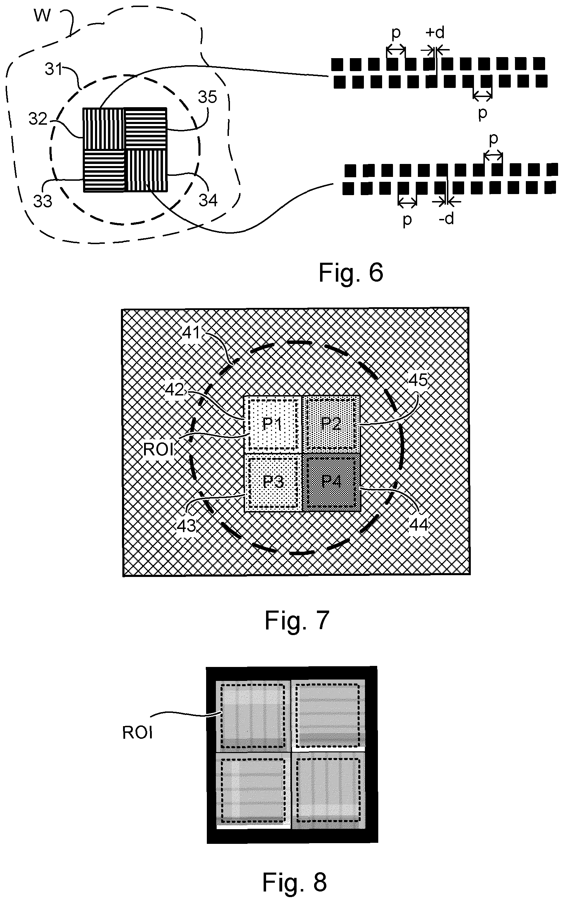

Figure 6 depicts an example (composite) µDBO target formed on a substrate W according to known practice. The target in this example comprises four sub-targets 32 to 35 positioned closely together so that they will all be within a measurement spot 31 formed by the metrology radiation illumination beam of the metrology apparatus. The four sub-targets, when measured with the apparatus of Figure 5, are all simultaneously illuminated and simultaneously imaged on sensors 19 and 23. In an example dedicated to measurement of overlay, sub-targets 32 to 35 are themselves composite gratings formed by overlying sub-gratings that are patterned in different layers of the semi-conductor device formed on substrate W. Sub-targets 32 to 35 may have differently biased overlay offsets in order to facilitate measurement of overlay between the layers in which the different parts of the composite sub-targets are formed. Sub-targets 32 to 35 having a pitch p may also differ in their orientation, as shown, so as to diffract incoming radiation in X and Y directions. In one example, sub-targets 32 and 34 are X-direction sub-targets with biases of the +d, -d, respectively. Sub-targets 33 and 35 are Y-direction sub-targets with offsets +d and -d respectively. Separate images of these sub-targets can be identified in the image captured by sensor 23. This is only one example of a target. A target may comprise more or fewer than 4 sub-targets, or only a single sub-target.

Figure 7 shows an example of an image that may be formed on and detected by the sensor 23, using the target of Figure 6 in the apparatus of Figure 5, using the aperture plates 13NW or 13SE from Figure 5(d). While the pupil plane image sensor 19 cannot resolve the different individual sub-targets 32 to 35, the image sensor 23 can do so. The dark rectangle represents the field of the image on the sensor, within which the illuminated spot 31 on the substrate is imaged into a corresponding circular area 41. Within this, rectangular areas 42-45 represent the images of the sub-targets 32 to 35. If the targets are located in product areas, product features may also be visible in the periphery of this image field. Image processor and controller processes these images using pattern recognition to identify the separate images 42 to 45 of sub-targets 32 to 35. In this way, the images do not have to be aligned very precisely at a specific location within the sensor frame, which greatly improves throughput of the measuring apparatus as a whole.

Once the separate images of the sub-targets have been identified, the intensities of those individual images can be measured, e.g., by averaging or summing selected pixel intensity values over a respective region of interest (ROI) within each of the identified images 42 to 45 of sub-targets 32 to 35. The ROI may comprise a central region P1, P2, P3, P4 of each image 42 to 45, away from the edges, for example. Intensities and/or other properties of the images can be compared with one another. These results can be combined to measure different parameters of the lithographic process. Overlay performance is an important example of such a parameter.

To determine the ROIs of each sub-target on a target image such as the image of Figure 7, the center of the target image is found such that separate target images (e.g., for at least a single measurement) can be aligned. Typically there are at least two, e.g., four (or more), separate target images per single measurement. These target images comprise normal and complementary images (typically a +1 diffraction image and a -1 diffraction image forming a pair of target images) for each of two substrate orientations (separated by 180 degrees, e.g., a 0 degree pair of +1, -1 images and a 180 degree pair of +1, -1 images). These images may be obtained in a two measurement captures (e.g., respective captures at each of the substrate orientations). The reason for obtaining a pair of target images (e.g., +1 and -1 images) per substrate orientation is to mitigate, compensate and/or correct for optical irregularities or asymmetries of the metrology apparatus (i.e., the so-called tool-induced shift TIS).

It is important to align the images such that they can be properly compared. The parameter of interest (e.g., overlay) is determined by a comparison (e.g., a difference or ratio) of the normal and complementary images, averaged over the two substrate orientations. The best accuracy is achieved when the ROIs for each image properly correspond (i.e., each corresponding ROI from the respective target images all relate to the same region of the measured target). Presently, the target images are aligned to find their center using a pattern recognition algorithm. This may be done by comparing each target image to a reference template, which is a simple representation of a target, e.g., a target comprising four sub-targets arranged in the manner of a µDBO target.

The present pattern recognition algorithm used typically finds the target image center within a range of +1 to -1 pixels, with a reasonably normal distribution within this range. This has provided satisfactorily performance up to now, based on one or both of present performance requirements and the target sizes presently used, which typically may be in the region of 10µm×10µm in size.

However, there is a desire to use increasingly smaller targets, e.g., 8µm×8µm, 6µm×6µm or 5µm×5µm (the sizes are approximate and it may be that the targets are not necessarily truly square, but slightly oblong). As target sizes decrease, the number of pixels comprised within each sub-target image region, that are available for defining an ROI, becomes smaller. Additionally, oscillations in intensity due to the Gibbs phenomenon are more pronounced in the ROI of smaller targets. Even for targets of present size or larger, present pattern recognition methods may no longer be sufficient for more stringent performance requirements going forward.

Figure 8 is an example schematic representation of a target image of such a target where these oscillations are clearly visible as a striping of the intensity (represented by the shading) within each ROI region.

The combination of these oscillations and smaller ROIs means that the present pattern recognition techniques may not necessarily be sufficiently accurate for aligning images and/or locating the ROIs of small targets (e.g., smaller than 10µm square). A single pixel (or more) misalignment or position error for an image, where there is an oscillation fringe resulting in a large intensity difference between neighboring pixels and where there are fewer pixels to average over, can result in a measurement error for the averaged intensity and therefore the parameter of interest. Such positional errors also impact dynamic precision resulting in a larger residual, worse matching, the need for increased sensor asymmetry corrections and a less accurate determination of any health performance indicators.

It should be appreciated that even the effect of a single pixel misalignment range has a greater impact overall as the centers of the four target images (the normal, complementary, normal 180° rotated and the complementary 180° rotated image) are determined independently of each other. Additionally, the sizes of the area for which the mean values are computed (e.g., the sizes of the ROIs), may vary between the four images and between target locations.

In view of the more stringent performance requirements, methods according to the invention disclosed herein may comprise aligning each target image to an application-specific reference image. Application-specific in this context may mean that a different reference image is used per product per layer, and/or per pattern. Additionally, the reference image may be acquisition setting dependent, where the acquisition setting may describe any setting or combination of settings used in acquiring the images, and which may affect the image. An acquisition setting may describe any one or more (e.g., any combination) of wavelength, polarization, illumination aperture and/or illumination angle of incidence of the measurement illumination, used to obtain the target images. The reference image may be a target image acquired during data acquisition for recipe set up or a target image acquired during production metrology (e.g., one target image of the first measurement of a substrate, lot or other batch of substrates of a particular application). The reference image may even be the other of a corresponding pair of images (e.g., the complementary image may be aligned to the normal image or *vice versa*). Alternatively, a reference image may be a simulated or representative image which is known or is determined to provide similar alignment performance to the target images for the particular application of interest.

An aim of the methods described herein is to align the target images to each other instead of running a pattern recognition on each image individually. This means that the ROIs will be placed more consistently between the different images, and therefore the signal extraction is performed from the same part of each target image. This can be achieved by aligning the normal image directly to the complementary image (i.e., where one of the normal and complementary images is the application specific reference image for the other), after one of the normal and complementary images has been rotated 90 degrees (or each rotated a corresponding amount). Alternatively, each of the normal and complementary images may be aligned to another application specific reference image as has been described, with at least one of images rotated as appropriate, e.g., such that in each case the reference and the image being compared thereto have a common orientation.

The method may comprise, as an initial step, rotating one or both of the normal target images and complementary target images such that the normal and complementary images resemble each other. This may comprise rotating either of the normal target images or the complementary target images by 180 degrees, although it can be achieved by rotating both normal and complementary images such that the difference in rotation between the normal and complementary images is 180 degrees in magnitude (e.g., rotating the normal images by 90 degrees and the complementary images by -90 degrees or *vice versa*). Alternatively, the reference image may be rotated prior to comparison to at least one of the normal and complementary image. Of course, any such rotation may be achieved mathematically, prior to comparison to a reference image, rather than actually rotating an image.

It can be appreciated that the physical relationship between the normal and complementary image means that the complementary image is approximately the 180° rotated normal image (theoretically it can be demonstrated that for zero overlay, these images will be the same). This relationship allows for alignment of the four images on sub-pixel level.

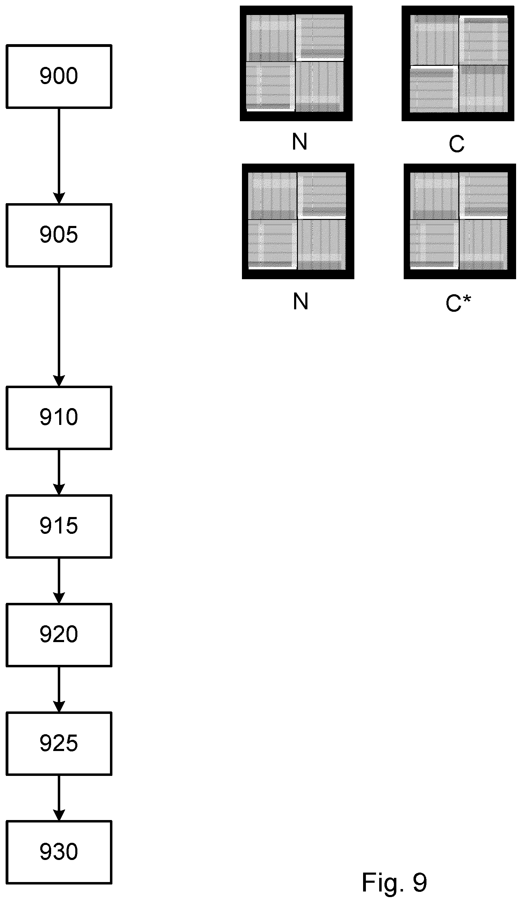

Figure 9 is a flow diagram according to a method according to concepts disclosed herein. The method comprises obtaining at step 900 at least one pair of target images, a normal target image N and complementary target image C. There may be two such pairs (not shown) per measurement, e.g., a pair of target images per substrate orientation.

At step 905, one of the target images (here the complementary target image) may be rotated 180 degrees to obtain a rotated complementary target image C*. Alternatively, the application specific reference image may be rotated to obtain a rotated reference image.

At step 910, an optional initial or coarse center recognition step may be performed to find the target image centers (or other common point), e.g., using the current pattern recognition algorithm as has been described. Alternatively, this step may be skipped and the alignment to a reference image (step 915) may be performed immediately.

At step 915, a fine or sub-pixel image alignment step or center recognition step is performed, i.e., using the application specific reference image as has already been described. Any suitable image recognition method and/or algorithm may be used to determine the image centers with respect to the reference image. In particular, the comparison of a target image with a reference image may compare the images having a corresponding or common orientation. As such, target image and reference image being compared may have had one (or both) of the target image or reference image rotated and/or reoriented (e.g., at step 905) so as to maximize their resemblance (e.g., they are at a mutual orientation which maximizes their similarity).

Note that, strictly speaking, any common point for the targets may be determined in this step 915. The center point is chosen for convenience, but the concepts should be understood to cover the recognition of any common point for the image, such that they can be aligned together.

Step 915 may comprise shifting each target image over the reference image (or *vice versa*) and a correlation metric or matching metric is compared, with the center determined as when the correlation metric is maximized. By way of specific example, the correlation metric may comprise a normalized cross-correlation metric, such the target image is shifted with respect to the reference image until the normalized cross-correlation between the images is maximized. Alternatively, or in addition, this step may comprise determining the (e.g., normalized) cross-correlation for two or more relative shifts between the target image and reference image (e.g., for a couple of said shifts), and fitting a parabola (e.g., a 2D polynomial of order 2 or a (e.g., 2D) Gaussian to find the maximum (e.g., normalized) cross-correlation. As such, the method may comprise optimizing a suitable correlation metric.

Optionally, prior to the center recognition step 915, the target images and reference images may be resized (e.g., by a scale between 2 and 50, 2 and 20, 5 and 20 or approximately 10). The resizing may use any pixel interpolation technique to interpolate between pixels. For example, a bilinear (or bicubic or any other) transformation to resize images (mathematically) to enable sub-pixel alignment. In the example of 10x resizing, the positioning accuracy may be achieved to within 0.1 pixels. Note that the fitting alternative described in the previous paragraph obviates any requirement for such a resizing sub-step.

The correlation metric value or normalized cross-correlation metric value (a number between - 1 and 1) could be used as a performance indicator to monitor and/or assess the alignment performance. For example, if the correlation is too small (e.g., smaller than a threshold such as purely for example 0.9), the measurement may be flagged.

The result of the fine sub-pixel center recognition step is that all (e.g., two, four) target images per measurement are aligned to the reference image, e.g., at a sub-pixel level.

The remaining steps are essentially no different to present metrology (e.g., µDBO metrology) methods. At step 920, the regions of interest are determined per sub-target, and one or more representative (e.g., a mean, median or smart subset selection) measurement parameter values (e.g., representative intensity values) are calculated per ROI. At step 925, a TIS correction may be performed, e.g., by taking the average (e.g., mean intensity) of the target images over the two substrate orientations, per diffraction order (i.e., per normal and complementary images). The result is a single averaged normal target image or value (depending on what is done first: if image averaging is done first, an averaged image will be obtained; if intensity extraction is done first, an averaged representative value will be obtained) and a single averaged complementary image or value. At step 930, the parameter of interest (e.g., overlay) is determined from a comparison (e.g., difference) of the single averaged normal target image/value and single averaged complementary image/value (e.g., from such difference values as calculated respectively per sub-target). Such a parameter of interest determination may use any techniques for mitigating/correcting for nuisance asymmetries in the targets, as is well known and described in the prior art (the two biased sub-targets per measurement direction are provided for this purpose).

In an embodiment, the reference image may be acquisition setting dependent and may be stored as part of the measurement recipe. Moreover, multiple reference images per *inter alia* acquisition setting could be stored (for example, for every field location) in a library of reference images. More generally, the reference image may be dependent on one or more of acquisition settings, different applications, different substrates, different exposure and/or metrology tools, different exposure settings (e.g., focus and/or dose) and/or different substrate locations, and the library of reference images may include examples of at least one or more of these categories.

To increase the signal-to-noise ratio, the reference image may be updated by averaging more than one image, e.g., averaging at least some of the target images with the original reference image as they are acquired to obtain an (e.g., updated) averaged reference image.

An advantage of using a reference image which is selected from the recipe set-up is that the areas (ROIs) for which the representative values are to be computed can be manually selected (with for example a proposed area). This allows for a maximum sized area, which will result in a better static precision. In such an embodiment, a user interface (e.g., a graphic user interface) may be configured to facilitate this possibility and enable a user friendly method for manually selecting the regions of interest. However, an automatic selection is possible also.

The metrology targets measured using concepts disclosed herein may be smaller than 10µm, smaller than 9µm, smaller than 8µm, smaller than 7µm or smaller than 6µm in one or both directions of the substrate plane.

By making the pattern recognition more stable, a more accurate and precise parameter of interest (e.g., overlay) measurement is possible.

The methods described above relate to overlay targets for the measurements of overlay. However other parameters of interest (e.g., focus) may be measured using targets for which target asymmetry is dependent on the parameter of interest. In this regard, the dark-field measurement branch of a metrology apparatus such as illustrated in Figure 5 typically measures structure or target asymmetry via an intensity asymmetry of a pair of corresponding diffraction orders (the normal and complementary diffraction orders or +1 and -1 diffraction orders) diffracted from the target. Different target types may designed such that a parameter of interest varies predictably with the measurable target asymmetry. Many of these other metrology methods may also benefit with improved alignment and center recognition of the target images, and therefore may benefit from the method disclosed herein.

The targets may comprise sub-targets for each direction of the substrate plane (as has been described) or for only one direction of the substrate plane (in which case µDBO targets may comprise only two sub-targets, for example).

Note that, while it is typical for the normal and complementary images to be obtained from the +1 and -1 diffraction orders (as these will be the strongest orders and in the most convenient locations for capture), they can technically comprise images from any pair of non-zero diffraction orders (e.g., the +2 and -2 orders). It is even possible, for example to use +1 and +2 diffraction order in the normal image and -1 and -2 in the complementary image *or vice versa*) to extract the overlay.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

The foregoing description of the specific embodiments will so fully reveal the general nature of the invention that others can, by applying knowledge within the skill of the art, readily modify and/or adapt for various applications such specific embodiments, without undue experimentation, without departing from the general concept of the present invention. Therefore, such adaptations and modifications are intended to be within the meaning and range of equivalents of the disclosed embodiments, based on the teaching and guidance presented herein. It is to be understood that the phraseology or terminology herein is for the purpose of description by example, and not of limitation, such that the terminology or phraseology of the present specification is to be interpreted by the skilled artisan in light of the teachings and guidance.

The breadth and scope of the present invention should not be limited by any of the above-described exemplary embodiments, but should be defined only in accordance with the following claims and their equivalents.

Further embodiments according to the invention are described in below numbered clauses:
1. A method of determining a common point for each target image of at least one pair of target images, the method comprising:
   obtaining the at least one pair of target images, each pair of target images of the at least one pair of target images comprising a normal target image and a complementary target image, the normal target image being obtained from a normal diffraction order of a pair of corresponding diffraction orders as diffracted from a target on a substrate and the complementary target image being obtained from a complementary diffraction order of the pair of corresponding diffraction orders; and
   determining the common point for each target image of the at least one pair of target images by referring each target image to an application specific reference image.
2. The method as claimed in claim 1, wherein the application specific reference image is specific for a particular product and/or layer being exposed on the substrate.
3. The method as claimed in claim 1 or 2, wherein the application specific reference image comprises a previously captured target image.
4. The method as claimed in claim 3, wherein the previously captured target image has been captured from measurement of a previously measured target on the same substrate, same lot of substrates or same batch of substrates.
5. The method as claimed in claim 4, wherein the previously measured target comprises at least a first measured target of the same substrate, same lot of substrates or same batch of substrates.
6. The method as claimed in claim 3, wherein the previously captured target image has been captured during a measurement recipe setup for measuring the target.
7. The method as claimed in any preceding claim, wherein the application specific reference image comprises an averaged reference image, comprising an average of more than one previously captured target images.
8. The method as claimed in any preceding claim, comprising averaging at least one target image of the at least one pair of target images with the application specific reference image to obtain an updated averaged reference image.
9. The method as claimed in claim 1 or 2, wherein the application specific reference image referred to for determining the common point of the normal target image comprises the complementary target image and/or the application specific reference image referred to for determining the common point of the complementary target image comprises the normal target image.
10. The method as claimed in claim 1 or 2, wherein the application specific reference image is a representative and/or simulated image which has been determined to provide similar alignment performance to the at least one pair of target images.
11. The method as claimed in any preceding claim, wherein the application specific reference image comprises an application specific and acquisition setting specific reference image, being specific for the acquisition setting used to measure the target to obtain the at least one pair of target images.
12. The method as claimed in claim 11, wherein the acquisition setting comprises any one or more of, alone or in combination: an illumination wavelength, an illumination polarization, an illumination angle of incidence and/or an illumination aperture.
13. The method as claimed in any preceding claim, wherein determining the common point for each target image of the at least one pair of target images, comprises comparing each target image against the application specific reference image until a matching metric or correlation metric is optimized.
14. The method as claimed in claim 13, wherein the matching metric or correlation metric comprises normalized cross-correlation.
15. The method as claimed in claim 13 or 14, wherein determining the common point comprises varying a relative shift between each target image and the application specific reference image.
16. The method as claimed in claim 15, wherein the relative shift is varied between each target image and the application specific reference image until the matching metric or correlation metric is optimized.
17. The method as claimed in claim 15, comprising determining the matching metric or correlation metric for at least two relative shifts; and fitting a function to optimize the matching metric or correlation metric.
18. The method as claimed in claim 17, wherein the function comprises a two dimensional parabola or Gaussian function.
19. The method as claimed in any of claims 13 to 18, comprising using the matching metric or correlation metric as a performance indicator.
20. The method as claimed in any preceding claims, wherein the application specific reference image is obtained from a library of reference images, determined for one or more of: acquisition settings, different applications, different substrates, different exposure and/or metrology tools, different exposure settings and/or different substrate locations.
21. The method as claimed in any preceding claims, comprising an initial step of rotating at least one target image of the at least one pair of target images and/or the reference image so as to maximize a similarity of the target images and the application specific reference image.
22. The method as claimed in claim 21, wherein rotating at least one target image of the at least one pair of target images and/or the application specific reference image comprises rotating the at least one target image and/or the reference image by 180 degrees.
23. The method as claimed in any preceding claim, comprising, prior to the step of determining the common point, rescaling the application specific reference image and each target image of the at least one pair of target images.
24. The method as claimed in claim 23, wherein rescaling rescales the application specific reference image and each target image by a scaling factor between 2 and 50.
25. The method as claimed in claim 23 or 24, wherein rescaling uses a pixel interpolation technique to interpolate between pixels of each image.
26. The method as claimed in any preceding claim, comprising, subsequent to the step of determining the common point:
   determining at least one region of interest for each target image of the at least a pair of target images; and
   determining a representative measurement parameter value for each of the at least one region of interest to obtain a plurality of representative measurement parameter values.
27. The method as claimed in claim 26, comprising determining a parameter of interest from the plurality of representative measurement parameter values.
28. The method as claimed in claim 27, wherein the parameter of interest is overlay or focus.
29. The method as claimed in claim 27 or 28, comprising: determining a process correction based on the determined parameter of interest.
30. The method as claimed in claim 29, comprising performing a subsequent exposure action based on the process correction.
31. The method as claimed in any of claims 26 to 30, wherein each representative measurement parameter value comprises an average measurement parameter value, being an average for all measurement parameter values within its respective region of interest.
32. The method as claimed in any of claims 26 to 31, wherein the representative measurement parameter value comprises a representative intensity value.
33. The method as claimed in any of claims 26 to 32 comprising determining each at least one region of interest using a user interface.
34. The method as claimed in any preceding claim, wherein the common point is a center of each target image.
35. The method as claimed in any preceding claim, wherein the at least one pair of target images comprises a pair of target images for each of two substrate orientations.
36. The method as claimed in claim 35, comprising, for each of the normal target images and complementary target images, determining a representative target image or value therefor, representing the target images over the two substrate orientations.
37. The method as claimed in any preceding claim, wherein the target is smaller than 9 µm in one or both directions of a substrate plane defined by the substrate.
38. The method as claimed in any preceding claim, wherein the target comprises two or more sub-targets.
39. The method as claimed in any preceding claim, wherein the target comprises four or more sub-targets.
40. The method as claimed in any preceding claim, comprising illuminating the target and imaging at least one pair of corresponding diffraction orders from the target to obtain the at least one pair of target images.
41. A computer program comprising program instructions operable to perform the method of any preceding claim, when run on a suitable apparatus.
42. A non-transient computer program carrier comprising the computer program of clause 41.
43. A processing arrangement comprising:
   a non-transient computer program carrier comprising a computer program comprising program instructions operable to perform the method of any of claims 1 to 40, when run on a suitable apparatus; and
   a processor operable to run the computer program comprised on the non-transient computer program carrier.
44. A metrology apparatus comprising the processing arrangement of claim 43.
45. A metrology apparatus as claimed in claim 44, comprising a scatterometer apparatus.
46. A metrology apparatus as claimed in claim 44 or 45, comprising a dark-field scatterometer apparatus.
47. A metrology apparatus as claimed in claim 44, 45 or 46 comprising:
   a support for a substrate;
   an optical system for illuminating a target on the substrate with measurement radiation; and a detector for detecting the measurement radiation scattered by the target to capture the at least one pair of target images.

## Claims

1. A method of determining a common point for each target image of at least one pair of target images, the method comprising:
obtaining the at least one pair of target images, each pair of target images of the at least one pair of target images comprising a normal target image and a complementary target image, the normal target image being obtained from a normal diffraction order of a pair of corresponding diffraction orders as diffracted from a target on a substrate and the complementary target image being obtained from a complementary diffraction order of the pair of corresponding diffraction orders; and
determining the common point for each target image of the at least one pair of target images by referring each target image to an application specific reference image.

2. The method as claimed in claim 1, wherein the application specific reference image is specific for a particular product and/or layer being exposed on the substrate.

3. The method as claimed in claim 1 or 2, wherein the application specific reference image comprises a previously captured target image.

4. The method as claimed in claim 3, wherein the previously captured target image has been captured from measurement of a previously measured target on the same substrate, same lot of substrates or same batch of substrates.

5. The method as claimed in claim 4, wherein the previously measured target comprises at least a first measured target of the same substrate, same lot of substrates or same batch of substrates.

6. The method as claimed in claim 3, wherein the previously captured target image has been captured during a measurement recipe setup for measuring said target.

7. The method as claimed in any preceding claim, wherein the application specific reference image comprises an averaged reference image, comprising an average of more than one previously captured target images.

8. The method as claimed in any preceding claim, comprising averaging at least one target image of the at least one pair of target images with the application specific reference image to obtain an updated averaged reference image.

9. The method as claimed in claim 1 or 2, wherein the application specific reference image referred to for determining the common point of the normal target image comprises the complementary target image and/or the application specific reference image referred to for determining the common point of the complementary target image comprises the normal target image.

10. The method as claimed in claim 1 or 2, wherein the application specific reference image is a representative and/or simulated image which has been determined to provide similar alignment performance to the at least one pair of target images.

11. The method as claimed in any preceding claim, wherein the application specific reference image comprises an application specific and acquisition setting specific reference image, being specific for the acquisition setting used to measure the target to obtain the at least one pair of target images.

12. The method as claimed in claim 11, wherein the acquisition setting comprises any one or more of, alone or in combination: an illumination wavelength, an illumination polarization, an illumination angle of incidence and/or an illumination aperture.

13. The method as claimed in any preceding claim, wherein determining the common point for each target image of said at least one pair of target images, comprises comparing each target image against the application specific reference image until a matching metric or correlation metric is optimized.

14. The method as claimed in claim 13, wherein the matching metric or correlation metric comprises normalized cross-correlation.

15. The method as claimed in claim 13 or 14, wherein determining the common point comprises varying a relative shift between each target image and the application specific reference image.
